# EUROPEAN PATENT SPECIFICATION

(11) **EP 0 425 589 B1**
(45) Date of publication and mention of the grant of the patent: **27.07.1994**
(21) Application number: 90901492.0
(22) Date of filing: 20.12.1989
(51) Int. Cl.: C30B 23/02

(54) **PLASMA/RADIATION ASSISTED MOLECULAR BEAM EPITAXY METHOD AND APPARATUS**
Durch Plasma/Strahlung unterstütztes Molekularstrahl-Epitaxieverfahren und Vorrichtung
PROCEDE ET APPAREIL D'EPITAXIE PAR FAISCEAU MOLECULAIRE A L'AIDE DE PLASMA/RAYONNEMENT

(30) Priority: 13.01.1989 US 281309
(43) Date of publication of application: 08.05.1991
(73) Proprietor: Hughes Aircraft Company, Los Angeles, California 90045-0066 (US)
(72) Inventor: BEATTIE, John R., Westlake Village, CA 91361 (US); MATOSSIAN, Jesse N., Woodland Hills, CA 91367 (US); WU, Owen K., Agoura, CA 91301 (US); LAM, Juan F., Agoura Hills, CA 91301 (US); HYMAN, Julius, Jr., Los Angeles, CA 90035 (US); ANDERSON, C. Lawrence, Malibu, CA 90265 (US)
(74) Representative: Colgan, Stephen James
(86) International application number: US8905835
(87) International publication number: WO9008210

(56) References cited:
- GB-A- 2 127 439
- US-A- 4 394 210
- Proceedings of the 1st Photovoltaic Science and Engineering Conference in Japan, 1979, Japanese Journal of Applied Physics, volume 19, supplement 19-2, 1980, Tokyo, JP; K. Takenaka et al.: "Plasma-assisted deposition of GaAs thin films" pages 183-186
- Japanese Journal of Applied Physics, volume 22, no. 9, part 2, September 1983, Tokyo, JP; K. Matsushita et al.: "Heavily Te-doped GaAs layers by plasma-assisted epitaxy", pages L602-L604
- Patent Abstracts of Japan, volume 13, no. 249 (C-605)(3597), 9 June 1989; & JP-A-1 56 397
- Japanese Journal of Applied Physics, Supplements, 16th Int. Conf. Solid State Devices and Materials, Kobe, 30 August - 1 September 1984, Tokyo, JP;T. Isu et al.: "Silicon epitaxial growth by excited molecular beams of glow-discharge decomposed silane", pages 58-59
- Journal of Crystal Growth, vol. 54, 1981, North-Holland Publishing Company, Amsterdam, NL; J.P. FAURIE et al.: "Molecular beam epitaxy of II-VI compounds: CdxHg1-xTe", pp. 582-585
- Thin Solid Films, vol. 163, no. 1, September 1988, Elsevier Sequoia, Lausanne, CH; C. DESHPANDEY et al.: "Plasma assisted deposition techniques and synthesis of novel materials", pp. 131-147

## Description

### BACKGROUND OF THE INVENTION

### Field of the Invention

This invention relates to molecular beam epitaxial methods and apparatus for epitaxial growth of a compound upon a substrate.

### Description of the Related Art

The present invention is concerned in general with the growth of structures by molecular beam epitaxy (MBE), and in particular with the use of MBE for the epitaxial growth of mercury telluride (HgTe), cadmium telluride (CdTe) and mercury cadmium telluride (HgCdTe) single crystal alloys, and HgTe/HgCdTe superlattices. HgCdTe is difficult to prepare for use in detection devices by either bulk or epitaxial techniques. The most commonly used epitaxial growth process for these materials is currently liquid phase epitaxy. Although high performance infrared detectors have been realized with growth by liquid phase epitaxy, the technique cannot produce abrupt heterojunctions and superlattices required for advanced opto-electronic devices. A review of various growth techniques is provided in J.P. Faurie et al., "Latest Developments in the Growth of Hg₁₋ₓCdₓTe and CdTe-HgTe Superlattices by Molecular Beam Epitaxy", J. Vac. Sci. Technol. A, Vol. 1, No. 3, July-September 1983, pages 1593-97.

The MBE technique, on the other hand, is suitable for the growth of high quality epilayers, abrupt heterojunctions and alternate microstructures such as superlattices. This technique is described in J.P. Faurie et al., "Molecular Beam Epitaxy of II-VI Compounds: Hg₁₋ₓCdₓTe", J. Cryst. Growth, Vol. 54, No. 3, pages 582-85, 1981. However, the growth of HgCdTe by MBE is hard to control because of the excessive mercury re-evaporation from the surface during the deposition process.

MBE is a vacuum deposition process. The current implementation of the process uses several effusion cells, each cell comprising an electrically heated crucible containing one of the substances of the compound to be grown. Upon heating, the cells produce atomic or molecular beam fluxes of mercury, cadmium and tellurium. The fluxes are directed onto the surface of the substrate, where they react with each other and produce an epitaxial layer.

The growth rate of an MBE process is critically dependent upon the "sticking coefficient" of the materials being grown, i.e., the probability that a particle of the flux will adhere to the surface of the substrate. In the case of HgCdTe and HgTe/HgCdTe superlattice growth, the Hg sticking coefficient is very low. For a substrate temperature range of 170°-200°C, the Hg sticking coefficient has been found to vary between about 10⁻⁴ and 10⁻³. With conventional MBE growth, therefore, large Hg fluxes must be used. For example, as described in J.P. Faurie et al., "Molecular Beam Epitaxy of Alloys and Superlattices Involving Mercury", J. Vac. Sci. Technol., A3(1), 1985, pages 55-59, 1 kg of mercury is required to grow a 75 micron thick layer of Hg₁₋ₓCdₓTe. This is an undesirably high rate of mercury consumption, and also requires a relatively high substrate temperature. Furthermore, it is difficult to control the electrical properties and to attain abrupt junctions for heterostructures.

### SUMMARY OF THE INVENTION

In view of the above problems with the related art, the purpose of the present invention is to provide a new MBE method and apparatus that substantially increases the mercury sticking coefficient when used with a mercury compound, lowers both the amount of mercury consumption and the substrate temperature, provides a greater degree of control over both the growth and substrate conditions, and avoids unintended contamination of the growth material.

The invention accomplishes these purposes by providing one of the substances to be grown in the form of a highly ionized, low pressure plasma which, in the preferred embodiment, includes both ions and neutral particles of the substance, electrons, and also ionization and excitation radiation fields of the substance. Radiation can also be used by itself to assist epitaxial growth, but not as effectively as the full plasma. The plasma is formed by bombarding a neutral gas of the substance with electrons, the electron energy (discharge voltage), emission current and substance flow rate being controllable to control the relative proportions of ions and neutral particles, and of ionization as opposed to excitation radiation.

A chamber is described for forming the highly ionized, low pressure plasma which has an opening on one side for the simple outward diffusion of the plasma, without any special extraction facilities. Means are provided to introduce a gas of a desired substance such as mercury into the chamber, and for providing electrons to ionize and excite at least some of the gas. An anode is also provided within the chamber and maintained at a more positive voltage than the cathode to accelerate electrons and thereby produce ionization. Excitation radiation results from the spontaneous decay of excited gas particles, while ionization radiation results from ions and electrons recombining on interior surfaces. The substrate is held in the path of the plasma emitted from the chamber. Means are provided for forming a flux from the other substance of the desired compound, and directing that flux onto the substrate to react with the plasma. The electron discharge is a DC mechanism, and the pressure is kept relatively low within the approximate range of 133.3·10⁻⁵-133.3·10⁻⁴ Pa (10⁻⁵-10⁻⁴ Torr).

The described technique has been found to produce a marked increase in the mercury sticking coefficient, with an accompanying significant reduction in mercury consumption. Also, contamination of the plasma is avoided by employing a hollow cathode as the electron source with an emissive mix-free insert such as a rolled tantalum foil.

Further features and advantages of the invention will be apparent to those skilled in the art from the following detailed description of preferred embodiments, taken together with the accompanying drawings, in which:

### DESCRIPTION OF THE DRAWINGS

FIG. 1 is a simplified diagram showing the principal components employed in one embodiment of the plasma/radiation-assisted MBE apparatus of the present invention;
FIG. 2 is a sectional view, partly in block diagram form, of a discharge chamber used in a preferred form of the invention;
FIG. 3 is a sectional view of the preferred form of hollow cathode used as an electron source, including a high work function insert;
FIG. 4 is a diagram illustrating the mechanisms by which plasma and radiation are produced within the discharge chamber;
FIG. 5 is a graph of the results of a control demonstration in which HgTe was grown by MBE;
FIG. 6 is a graph comparing the results of a radiation assisted MBE growth of HgTe with the results illustrated in FIG. 5; and
FIG. 7 is a simplified diagram of another embodiment in which both substances to be grown are presented to the substrate as plasmas.

### DETAILED DESCRIPTION OF A PREFERRED EMBODIMENT

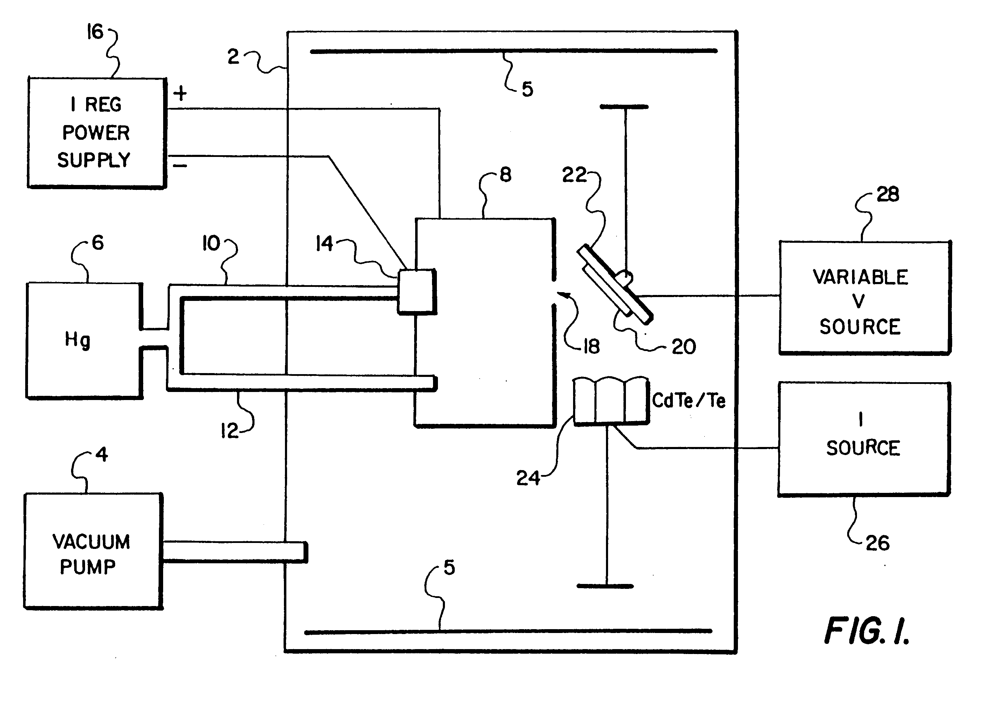

FIG. 1 illustrates the principal components of the apparatus employed in the present invention to produce a more efficient MBE. In accordance with the invention, one of the substances in a compound to be epitaxially grown is provided in the form of a highly ionized, low pressure plasma flux that includes neutral particles, ions, electrons, and both ionization and excitation radiation. The other substance of the compound is provided as a flux in either a vapor or plasma format. While FIG. 1 illustrates the preferred embodiment in which a plasma-delivered Hg is epitaxially grown together with evaporated Cd, Te or CdTe on a substrate, the invention is generally applicable to numerous compounds formed from Group II-VI and III-V combinations of the periodic table, and also to Group IV doping of compounds. However, because of the very substantial improvement offered to the sticking coefficient of Hg, the remainder of this specification will discuss this application of the invention.

The apparatus is enclosed within a vacuum housing 2, which is maintained at a pressure on the order of 133.3·10⁻⁷ Pa (10⁻⁷ Torr) by vacuum pump 4 and LN₂ cryowall 5. Hg from a source 6 is introduced into a cylindrical plasma discharge chamber 8 within the housing through flow lines 10 and 12. Hg flowing through line 10 is vaporized and enters the chamber through a hollow cathode 14, which is energized by a current-regulating power supply 16 to inject electrons into the chamber at a specified discharge voltage (V_{D}) and current (J_{E}). The electrons ionize at least some of the Hg vapor within the chamber, forming a weakly ionized, low pressure plasma consisting of a mixture of neutral Hg particles, ions, electrons, excitation radiation and ionization radiation. The exact mechanism by which the plasma is formed is explained in further detail below.

The plasma diffuses out of chamber 8 through an exit port 18 onto a crystalline substrate 20, which is supported on an electrically isolated, thermally controlled substrate holder 22. A crucible 24 is heated by a current source 26 to produce a flux of either molecular CdTe, Cd, or Te. The flux is directed onto the substrate 20, where it reacts with the Hg plasma to produce an epitaxial growth of the desired compound. The particular Hg plasma source shown was capable of supplying a flux on the order of 10¹⁶ ions/ sec/cm² (several mA/cm²) of low energy (on the order of 30 eV) Hg⁺ ions to the substrate, while with a substrate temperature fixed at 170°C a neutral Te₂ flux from crucible 24 was adjusted to produce an indicated partial pressure at the substrate location of 2 10⁻⁴ Pa (1.5 x 10⁻⁶ Torr) (about 2 x 10¹⁴ atoms/cm²/ sec). A significant increase in the Hg sticking coefficient compared to prior systems was noted, thus permitting a corresponding reduction in the Hg flux required for MBE growth.

In the system described thus far, the Hg plasma supplied to the substrate can be varied by changing V_{D} and/or J_{E} and/or the mercury flow rate. However, in some applications a very rapid change in the plasma reaching the substrate is desired, such as in the formation of superlattices with very abrupt boundaries between Hg and Te layers. In this case, a more rapid response in the plasma reaching the substrate might be achieved by applying a voltage signal from a variable voltage source 28 to the substrate 20, via substrate holder 22. The density of ions or electrons in the plasma reaching the substrate might then be controlled by biasing the substrate voltage either positive or negative. Although not yet demonstrated, it is believed that a very rapid response might be achieved with this technique.

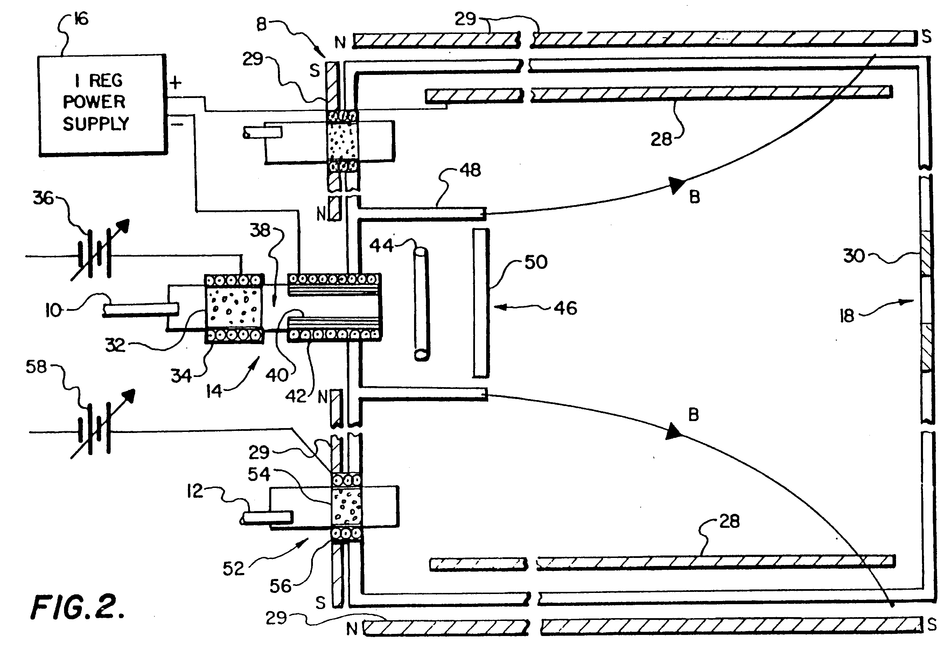

Further details of plasma chamber 8 are furnished in FIG. 2. A cylindrical anode 28 is positioned within the chamber adjacent to the cylindrical chamber wall between cathode 14 and exit port 18. The anode 28 serves to collect discharge current and plays a role in the production of neutral particles and ionization radiation, as discussed below. It is preferably water-cooled and coated with Cd, and is maintained at a positive voltage relative to the cathode. A divergent magnetic field which efficiently confines the low pressure, highly ionized plasma is produced by alnico permanent magnet bars 29 arranged along the perimeter of the discharge chamber.

The exit port 18 is preferably formed by a metal plate 30, such as stainless steel, which is coated with Cd and has a central opening approximately 7.5 cm in diameter. Unlike related ion thrusters which employ ion extraction mechanisms, the plasma inside the chamber simply diffuses out of exit port 18; a typical prior ion thruster is described in Harold R. Kaufman, "Technology of Electron-Bombardment Ion Thrusters", Advances in Electronics and Electron Physics, Vol. 36 (L. Marton, ed.) Academic Press, New York, 1974, pp. 265-373. Despite this, the large majority of the output from the plasma chamber may be ions, as opposed to neutral particles. This is because the ions are driven out by internal electric fields within the chamber, whereas neutral atoms are moved out by random thermal motion; since a relatively low temperature source is used, the density of neutral particles in the chamber output can be strictly limited. The interior of the discharge chamber, including the anode 28, is preferably coated with Cd to minimize sputter-induced impurities evolving from the plasma source.

The cathode 14 has a unique structure which prevents it from adding impurities to the Hg introduced into the chamber. Liquid Hg is fed through supply line 10, which terminates at a porous tungsten plug 32 in the cathode tube. Plug 32 is heated to a temperature of about 300°C by a surrounding heating coil 34, which is powered by a variable current source 36. The liquid Hg vaporizes and migrates through the pores of plug 32 to enter the cathode chamber 38. As the Hg vapor continues downstream, it passes through the interior of an insert sleeve 40, which is heated by an electric coil heater 42 to emit electrons into the Hg vapor passing through the insert. The design of the insert 40 is unique, and offers a distinct advantage over prior ion thrusters. Inserts employed in the past have typically been chosen to have a low work function, so that electrons can be easily emitted. A tungsten insert impregnated with BaO, having a work function of about 2-2.5 eV, has commonly been used. However, BaO is an emissive material which gives off oxide and Ba, Ca, and Al emissions that can contaminate the substrate.

In accordance with the present invention, an emissive-mix-free insert is used in the hollow cathode 14. The new insert is formed from a refractory metal, such as tantalum or tungsten, in the form of a foil which is rolled up in a hollow spiral. Tantalum is preferred because it is less brittle than tungsten. The work function of tantalum is about 4.4 eV. Once the plasma is lit the cathode heater can be turned off, and the plasma self-heats the cathode insert. Ions from the plasma bombard the cathode with an energy sufficient to heat the insert to thermionic emission temperatures.

A small loop anode 44 called a keeper is positioned within the discharge chamber immediately in front of hollow cathode 14. This device draws sufficient electron current to initiate and maintain the cathode discharge in the presence of low emission conditions and plasma fluctuations. The cathode is isolated from the main discharge chamber via a baffle system 46, consisting of a cylindrical baffle 48 surrounding the cathode exit, and a circular baffle plate 50 in-line with the cathode exit. The baffle system, typically 5-8 cm in diameter, tends to isolate the plasma in the cathode from that in the main discharge chamber. The magnetic field from the permanent magnet bars 29 efficiently confines the plasma.

Hg is also introduced directly into the discharge chamber through a main plenum 52. This is fed with liquid Hg from line 12, and includes a porous tungsten plug 54 which is heated by a surrounding electrical coil 56 supplied by a variable current source 58. As with the initial portion of the hollow cathode, a tungsten plug 54 in the main plenum is heated to about 300°C to vaporize the liquid Hg, which then migrates through the pores of the plug directly into the discharge chamber. The flow rate of mercury vapor produced by the main plenum plug 54 and cathode plug 32 can be adjusted by varying the currents applied to their respective heating coils.

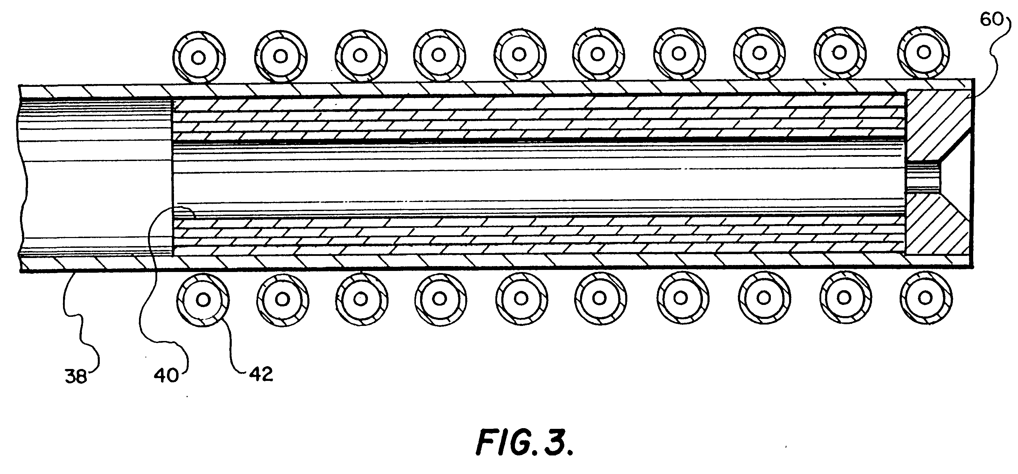

Further details of the hollow cathode are provided in FIG. 3. The emissive-mix-free tantalum insert 40 is formed from a foil about .013-mm thick, rolled in six or seven turns with an inside diameter of about 3.8-mm. The insert is about 25-mm long. The tube forming the cathode chamber 38 is about 6.4-mm in diameter, is preferably formed from Mo or Ta, and is surrounded by about thirteen turns of the heating coil 42 in the vicinity of the tantalum insert. An orifice plate 60 is positioned at the end of the cathode tube, and has a flared central opening with a minimum diameter of 0.76 mm to emit the Hg vapor and electrons into the discharge chamber. Orifice plate 60 is preferably formed from thoriated tungsten (W with about 2% Th). Hg is introduced into the discharge chamber through the hollow cathode 14 and main plenum 52 at a pressure preferably in the range of about 133.3 10⁻⁵-133.3 10⁻⁴ Pa (10⁻⁵ to 10⁻⁴ Torr).

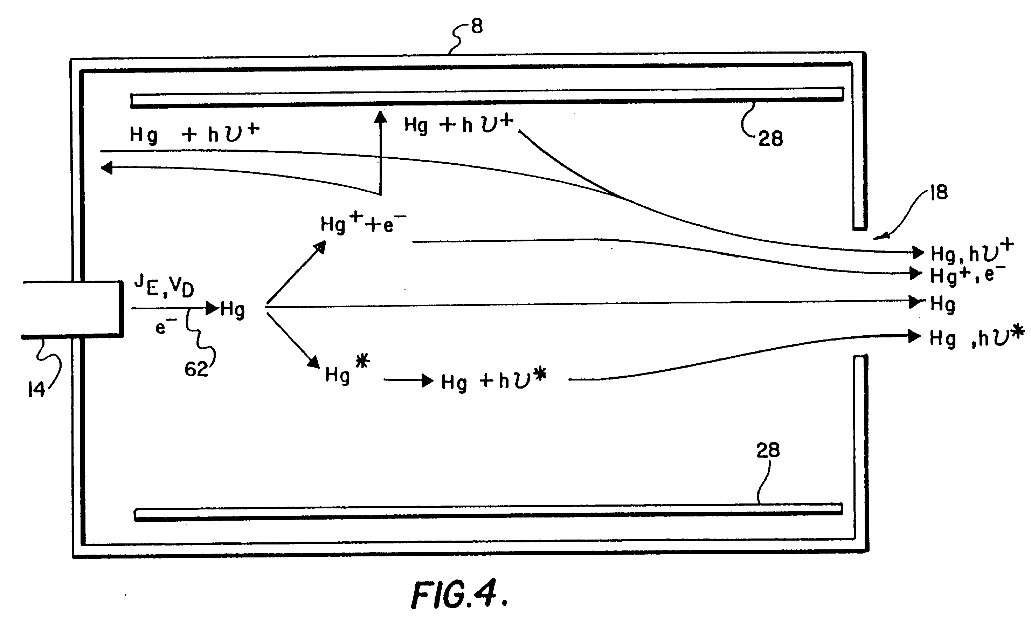

The manner in which a plasma consisting of neutral Hg particles, Hg ions, electrons, ionization radiation and excitation radiation is produced by the electrons supplied by cathode 14 is illustrated in FIG. 4. Electrons 62 are emitted from cathode 14 at a given discharge voltage V_{D} and current J_{E}. The electrons bombard neutral mercury atoms within the chamber. This bombardment will result in a combination of excited Hg* atoms, Hg⁺ ions and electron pairs, and neutral Hg atoms; the proportion of each is determined by the electron energy and plasma confinement conditions. There will also be a small number of Hg⁺⁺ ions produced, primarily by electron bombardment of Hg⁺, but for simplicity this reaction is not considered in this description. The excited Hg* atoms spontaneously decay to neutral Hg atoms, giving off excitation radiation hν*. The Hg⁺ ion and electron pairs either diffuse out of the discharge chamber, or to the anode 28, cathode 14, or cathode surfaces 8 where the ions and electrons recombine to form Hg atoms, giving off ionization energy hν⁺ in the process. The various proportions of Hg, Hg⁺, electrons, hν* and hν⁺ will all diffuse out of the discharge chamber and be applied to the substrate to participate in the epitaxial growth.

It has been found that the relative proportion of ions to neutrals and radiation can be varied by varying V_{D}, J_{E} and/or the mercury flow rate. V_{D} also controls the ion energy, and an ability to control this parameter is important in limiting the ion energy so that lattice damage is prevented during ion deposition. An ionization level of approximately 10% is preferably established.

The manner in which V_{D} can be controlled is known from the prior art of ion thrusters. To increase V_{D} for a constant cathode current J_{E}, the Hg flow rate through the cathode is first reduced by reducing the power from current source 36 (referring to FIG. 2). For a fixed cathode current, this will cause the discharge voltage V_{D} to increase. Since reducing the cathode flow rate reduces the amount of propellant introduced into the discharge chamber, the ion current exiting the source 36 will be reduced. To maintain this ion current constant, the Hg flow through the main plenum 52 is simultaneously increased. This will have a tendency to reduce the discharge voltage as well, but is easily compensated for by additionally reducing the cathode flow rate slightly. An increase in the discharge voltage in the manner described will always increase the ionization efficiency of the ionized substance (i.e., increase the ratio of ions to neutrals). The Hg flow through the cathode 14 and main plenum 48 can be varied in exactly the opposite manner to reduce V_{D} and shift the plasma away from ions and more towards neutral particles.

If it is desired to keep the ion energy fixed while increasing the ions/neutrals ratio, J_{E} is increased instead of V_{D}. To increase the proportion of ions, J_{E} is increased by adjusting power supply 16, leading to an increase in V_{D}. The flow of Hg through cathode 14 is then increased to cancel the rise in V_{D}. At the same time, the Hg flow rate through the main plenum 28 is reduced to maintain the absolute number of ions within the discharge chamber constant, but with an increased ion ratio because of the increase in J_{E}.

A large variation in the proportion of ions is possible with the present invention. An ion output of at least 90% has been demonstrated, without any form of ion extraction assembly.

Marked improvements have been noted in the Hg sticking coefficient. While the greatest improvement is achieved with a plasma consisting of neutral particles, ions, electrons, and both ionization and excitation radiation reaching the substrate, greater sticking coefficients have also been achieved with neutrals and both ionization and excitation radiation alone reaching the substrate. In one demonstration, a fine wire mesh was placed over the exit aperture 18 of the plasma chamber to prevent the Hg plasma from exiting. Instead, only Hg atoms and Hg-excitation and ionization radiation were allowed to impinge upon the substrate. In this experiment an ionization gauge was rotated into the location of the substrate to measure the Hg partial pressure and to verify that little, if any, plasma was reaching the substrate. The discharge chamber was operated to produce an Hg^{o} flux of 5x10¹⁵ atoms/cm²-sec (≃ 0.8 mA/cm²) to the substrate. As will be shown in the discussion below, this should have resulted in an Hg-deficient HgTe layer. The neutral Te₂ flux was adjusted to produce a partial pressure of 2·10⁻⁴ Pa (1.5x10⁻⁶ Torr) (1.9x10¹⁴ atom/cm²-sec) at the location of the substrate. In the presence of the Hg-excitation and ionization radiation emitted from the plasma source, an enhancement of about 10% in the Hg sticking coefficient was noted.

In another demonstration, a single crystal CdTe (111) substrate was confined within an LN₂-pumped vacuum system with a baseline vacuum pressure of 133.3 10⁻⁷ Pa (10⁻⁷ Torr), at a temperature of 170° C. Controlled fluxes of Te₂ and Hg atoms were produced by electrically heated crucibles, with the Te₂ and Hg fluxes directed onto the substrate. An exposed ionization gauge was rotated in the location of the substrate to measure the partial pressures of the fluxes. The Te₂ flux was maintained at a pressure of 2·10⁻⁴ Pa (1.5x10⁻⁶ Torr) (1.9x10¹⁴ atoms/cm²-sec). The Hg flux was then varied over three orders of magnitude, ranging from 3.2x10¹⁴ atoms/cm²-sec to 4x10¹⁶ atoms/cm2-sec.

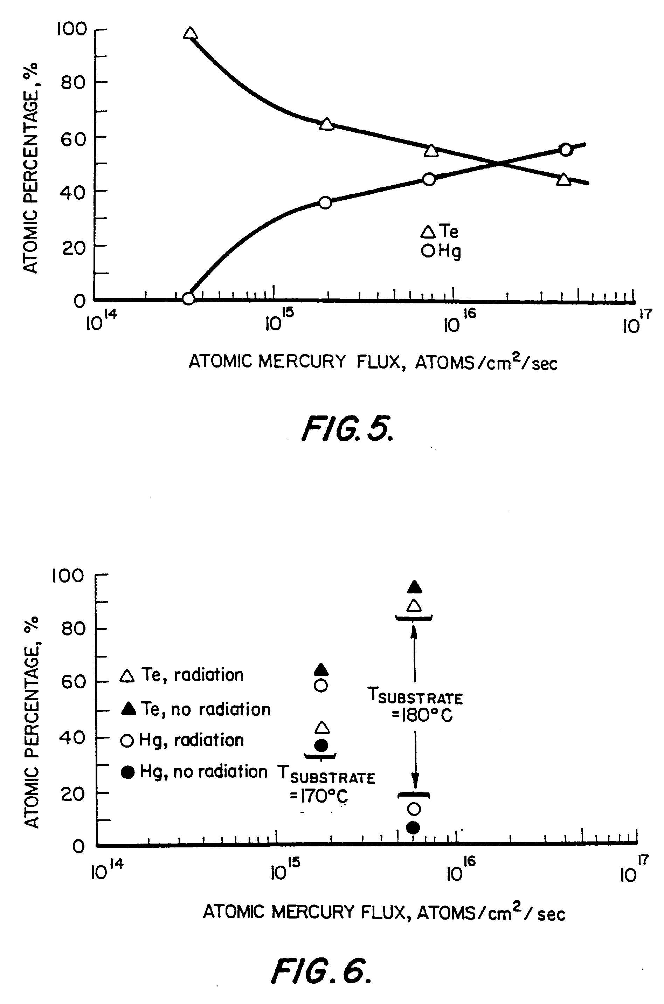

The variation of the atomic percentage concentration of Hg and Te in the grown HgTe films with the amount of incident Hg flux is charted in FIG. 5. The results indicate that for an incident Hg flux of less than 1.8x10¹⁶ atoms/cm²-sec, the grown HgTe films were Te-rich (Hg-deficient). For higher Hg fluxes, the films were Hg-rich (Te-deficient).

To assess the effect of a radiation assisted molecular beam epitaxy technique, the Hg^{o} flux was next set to a value of 1.8x10¹⁵ atoms/cm²-sec. Based upon the results illustrated in FIG. 5, this Hg^{o} flux would be expected to result in a Hg-deficient film. For this experiment, a Hg lamp which provided a radiation source with predominantly Hg-excitation radiation was mounted approximately 5 cm from the CdTe substrate. The lamp radiated at 255 nm, which is the first excitation potential of Hg. The power density of the lamp at a distance of 1.9 cm was 4.5 mW/cm².

The variation in the atomic percentage of Hg and Te in the HgTe films formed with and without the Hg-radiation lamp is shown in FIG. 6. In the presence of Hg excitation radiation, the Hg atomic percentage increased from a Hg-deficient level (approximately 35%) to Hg-rich (approximately 59%). In a further experiment the substrate temperature was increased from 170° C to 180° C, and the incident Hg^{o} flux was increased to 6x10¹⁵ atoms/cm²-sec. Under these conditions, the Hg atomic percentage again increased substantially, from 5% in the absence of the radiation field to 13% in the presence of the field.

The results shown in FIGs. 5 and 6 suggest that for HgTe films grown by conventional MBE techniques, the "sticking coefficient" of Hg^{o} atoms can be approximately doubled by performing the growth in the presence of Hg excitation radiation. It is anticipated that further enhancements can be achieved by optimum selections for the intensity of the light source, substrate temperature, and incident Hg and Te₂ flux conditions.

When a full plasma consisting of Hg⁺, Hg, electrons, ionization radiation and excitation radiation was applied from the discharge chamber described above, the Hg sticking coefficient was increased by a multiple of at least 40, with fluxes of about 90% Hg⁺ and about 10% Hg reaching the substrate. The wavelength of the excitation radiation was calculated as 259 nm, while that of the ionization radiation was calculated as 119 nm.

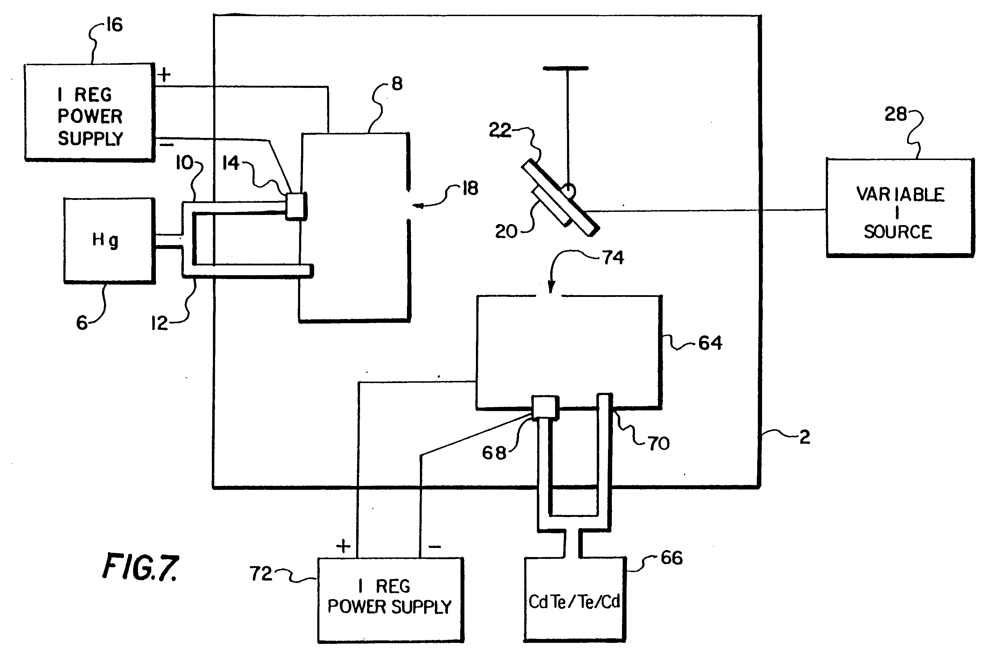

Referring now to FIG. 7, another embodiment of the invention is shown in which a flux of CdTe or Te plasma is provided from a second discharge chamber 64, rather than from a heated crucible. Discharge chamber 64 for CdTe, Cd or Te is similar to Hg discharge chamber 8, with a CdTe or Te source 66 supplying a cathode 68 and a main plenum 70; a current regulated power supply 72 is provided for cathode 68. A CdTe, Cd or Te plasma is emitted through exit port 74 onto the substrate 20, where it reacts with the Hg plasma to produce an epitaxial growth.

Various embodiments of a highly efficient MBE system have thus been shown and described. Since numerous variations and alternate embodiments will occur to those skilled in the art, it is intended that the invention be limited only in terms of the appended claims.

## Claims

1. A method of presenting one substance of a compound for molecular beam epitaxial (MBE) growth upon a substrate (20), comprising:
forming a plasma comprising a mixture of ions of said one substance, neutral particles of said one substance, and electrons,
generating radiation from said one substance, and
directing said radiation along with said plasma onto the substrate (20),
wherein said plasma is formed by bombarding a gas of said one substance with electrons.

2. The method of claim 1, wherein said gas is bombarded with electrons to produce ions and excited particles of said one substance, and said radiation comprises ionization radiation resulting from neutralization of at least some of said ions, and excitation radiation resulting from spontaneous decay of at least some of said excited particles.

3. The method of claims 1 or 2, wherein said plasma is formed by flowing a gas of said one substance into a chamber (8) through a hollow cathode (14), said hollow cathode (14) including an insert (40) formed from a material that is substantially free of any electron emissive mix, heating said insert (40) sufficiently for it to emit electrons into and at least partially ionize the gas flowing through the cathode (14), admitting a flow of gas of said one substance into the chamber (8) through an entrance port (52) separate from said cathode (14), and applying a voltage to the cathode (14) sufficient to establish the plasma within said chamber (8).

4. The method of claim 3, wherein said insert (40) comprises a rolled refractory metal foil.

5. The method of claim 4, wherein said insert (40) comprises tantalum.

6. The method of any of the preceding claims, wherein said plasma is formed in the chamber (8) and diffused through an opening (18) in the chamber (8) onto the substrate (20).

7. The method of claim 6 wherein a fine wire mesh is placed over the opening (18) in the chamber (8).

8. The method of any of the preceding claims, wherein said plasma is established at a relatively low pressure in the range of 133.3·10⁻⁵-133.3·10⁻⁴ Pa (10⁻⁵-10⁻⁴ Torr).

9. The method of any of the preceding claims, wherein said plasma is formed by a direct current (DC) discharge of electrons into a gas of said one substance.

10. The method of claim 9, wherein the relative proportions of ions and neutral particles in the plasma is controlled by controlling the voltage at which electrons are discharged into said gas and the discharge current.

11. The method of any of the preceding claims and further including the steps of:
forming a flux comprising particles of at least one other substance in said compound, and
directing said flux onto said substrate (20) to react with the plasma thereon.

12. The method of any of the preceding claims, wherein said plasma is established with an ionization level of approximately 10%.

13. The method of any of the preceding claims, further comprising the step of applying a voltage to said substrate (20) to control the incidence of charged particles thereon.

14. The method of claim 13, wherein said substrate voltage is varied during epitaxial growth upon the substrate to vary the density of ions or electrons in the plasma reaching the substrate.

15. The method of claim 11, wherein said flux of particles of said other substance comprises a molecular beam formed by evaporating a source (24) of said other substance.

16. The method of claim 11, wherein said flux of particles of said other substance comprises a plasma of said other substance.

17. The method of claim 16, wherein said flux further comprises ionization radiation resulting from neutralization of at least some of said ions of said other substance, and excitation radiation resulting from spontaneous decay of excited particles of said other substance.

18. A method according to claim 11 wherein the said one substance is mercury (Hg).

19. The method of claim 18, wherein said other substance is tellurium (Te₂).

20. The method of claim 18, wherein said other substance is cadmium telluride (CdTe).

21. An apparatus for epitaxially growing a compound having a plurality of constituent substances upon a substrate (20), comprising:
a chamber (18) having an opening (18) on one side for the emission of gas from within the chamber (8),
means for introducing a gas of one of said substances into said chamber,
means for discharging electrons into said chamber to ionize and excite at least some of said gas, the relative amounts of ionization and excitation depending upon the electron discharge voltage and emission current, with excited gas particles spontaneously decaying into neutral particles and excitation radiation,
an anode (28) within said chamber (8),
means (16) for maintaining said anode (28) at a more positive voltage than said chamber (8) to attract electrons and thereby initiate and sustain said electron discharge,
means (22) for holding the substrate (20) in the path of a gas, ion and radiation plasma emitted through said chamber opening (18) and
means (24) for forming a flux comprising particles of at least one other substance in said compound and for directing said flux onto the substrate (20) to react with said plasma thereon.

22. An apparatus according to claim 21 and further including:
a hollow cathode (14) extending into said chamber (8),
an insert (40) within said hollow cathode (14) that is substantially emissive-material-free, said insert (40) and hollow cathode (14) providing a flow path for a gas of said one substance into said chamber (8),
means for heating said insert (40) sufficiently for it to emit electrons into and at least partially ionize gas of said one substance flowing through said cathode (14) and insert (40),
an entrance port (60) separate from said insert (40) for admitting a flow of gas of said one substance into said chamber (8),
means for providing a flow of gas of said one substance into said chamber (8) through said insert (40) and said entrance port (60),
means (16) for applying a voltage to the cathode (14) sufficiently low relative to the anode (28) to produce an ionizing discharge between the cathode (14) and anode (28), and thereby establish a plasma within said chamber (8), when ionized gas is introduced into the chamber (8) through the cathode (14).

23. An apparatus according to claim 21 or 22 further comprising a fine wire mesh placed over the opening (18).

## Patentansprüche

1. Ein Verfahren zum Präsentieren einer Substanz einer Verbindung für eine Molekularstrahlepitaxie (MBE)-Aufwachsung auf ein Substrat (20), welches die Schritte umfaßt mit:
Ausbilden eines Plasmas, das eine Mischung aus Ionen der einen Substanz, neutralen Partikeln der einen Substanz und Elektronen umfaßt;
Erzeugen von Strahlung aus der einen Substanz; und
Führen der Strahlung zusammen mit dem Plasma auf das Substrat (20), wobei
das Plasma gebildet wird, indem ein Gas aus der einen Substanz mit Elektronen bombardiert wird.

2. Das Verfahren nach Anspruch 1, worin das Gas mit Elektronen bombardiert wird, um Ionen und angeregte Partikel der einen Substanz zu erzeugen, und wobei die Strahlung Ionisationsstrahlung umfaßt, die aus der Neutralisierung von wenigstens einigen der Ionen entsteht, sowie Anregungsstrahlung, die aus dem spontanen Zerfall von wenigstens einigen der angeregten Partikel resultiert.

3. Das Verfahren nach Anspruch 1 oder 2, worin das Plasma gebildet wird, indem man ein Gas aus der einen Substanz in eine Kammer (8) durch eine Hohlkathode (14) fließen läßt, wobei die Hohlkathode (14) einen Einlaß (40) enthält, der aus einem Material gebildet ist, das im wesentlichen frei von jeglichen, Elektronen emittierenden Mischungen ist, indem man den Einlaß (40) ausreichend erwärmt, damit es ihm möglich wird, Elektronen zu emittieren und das durch die Kathode (14) fließende Gas wenigstens teilweise zu ionisieren, indem man einen Fluß des Gases der einen Substanz in die Kammer (8) durch ein Eintrittstor (52) erlaubt, das von der Kathode (14) getrennt ist, und indem man eine Spannung an die Kathode (14) anlegt, die ausreichend ist, das Plasma innerhalb der Kammer (8) zu errichten.

4. Das Verfahren nach Anspruch 3, worin der Einlaß (40) aus einer gerollten feuerfesten Metallfolie besteht.

5. Das Verfahren nach Anspruch 4, worin der Einlaß (40) aus Tantal besteht.

6. Das Verfahren nach einem der vorigen Ansprüche, worin das Plasma in der Kammer (8) gebildet wird und durch eine Öffnung (18) in der Kammer (8) auf das Substrat (20) diffundiert.

7. Das Verfahren nach Anspruch 6, worin ein feines Drahtnetz über der Öffnung (18) in der Kammer (8) plaziert wird.

8. Das Verfahren nach einem der vorigen Ansprüche, worin das Plasma bei einem vergleichsweise niedrigen Druck in dem Bereich von 133,3 x 10⁻⁵ bis 133,3 x 10⁻⁴ Pa (10⁻⁵ bis 10⁻⁴ Torr) erzeugt wird.

9. Das Verfahren nach einem der vorigen Ansprüche, worin das Plasma durch eine Gleichstrom (DC)-Entladung von Elektronen in ein Gas aus der Substanz gebildet wird.

10. Das Verfahren nach Anspruch 9, worin die relativen Anteile der Ionen und der neutralen Partikel in dem Plasma eingestellt werden, indem die Spannung geregelt wird, bei der die Elektronen in das Gas entladen werden, sowie der Entladungsstrom.

11. Das Verfahren nach einen der vorigen Ansprüche, welches des weiteren die Schritte umfaßt:
Ausbilden eines Flusses, der Partikel von wenigstens einer anderen Substanz der Verbindung enthält; und
Führen des Flusses auf das Substrat (20), damit es darauf mit dem Plasma reagiert.

12. Das Verfahren nach einem der vorigen Ansprüche, worin das Plasma mit einem Ionisationsniveau von ungefähr 10% erzeugt wird.

13. Das Verfahren nach einem der vorigen Ansprüche, das desweiteren den Schritt des Aufbringens einer Spannung auf das Substrat (20) umfaßt, um den Einfall von geladenen Partikeln darauf zu steuern.

14. Das Verfahren nach Anspruch 13, worin die Substratspannung während des epitaktischen Aufwachsens auf das Substrat variiert wird, um die Dichte der Ionen oder Elektronen in dem Plasma zu variieren, die das Substrat erreichen.

15. Das Verfahren nach Anspruch 11, worin der Fluß aus Partikeln der anderen Substanz einen Molekularstrahl umfaßt, der gebildet wird, indem eine Quelle (24) aus der anderen Substanz verdampft wird.

16. Das Verfahren nach Anspruch 11, worin der Fluß aus Partikeln der anderen Substanz ein Plasma aus der anderen Substanz umfaßt.

17. Das Verfahren nach Anspruch 16, worin der Fluß des weiteren Ionisationsstrahlung umfaßt, die aus der Neutralisierung von wenigstens einigen der Ionen der anderen Substanz resultiert, sowie Anregungsstrahlung, die aus dem spontanen Zerfall von angeregten Partikeln der anderen Substanz resultiert.

18. Das Verfahren nach Anspruch 11, worin die eine Substanz Quecksilber (Hg) ist.

19. Das Verfahren nach Anspruch 18, worin die andere Substanz Tellur (Te₂) ist.

20. Das Verfahren nach Anspruch 18, worin die andere Substanz Kadmium-Tellurid (CdTe) ist.

21. Eine Vorrichtung zum epitaktischen Aufwachsen einer Verbindung, die eine Mehrzahl von konstituierenden Substanzen umfaßt, auf ein Substrat (20), mit:
einer Kammer (8), welche eine Öffnung (18) auf der einen Seite aufweist, für die Emission eines Gases von innerhalb der Kammer (8) her;
einer Vorrichtung zum Einführen eines Gases aus einer der Substanzen in die Kammer;
einer Vorrichtung zum Entlassen von Elektronen in die Kammer, um wenigstens einen Teil des Gases zu ionisieren und anzuregen, wobei der relative Umfang der Ionisation und der Anregung von der Elektronenentladungsspannung und dem Emissionsstrom abhängt, wobei die angeregten Gaspartikel spontan in neutrale Partikel und Anregungsstrahlung zerfallen;
einer Anode (28) innerhalb der Kammer (8);
einer Vorrichtung (16) zum Halten der Anode (28) bei einer positiveren Spannung als die Kammer (8), um Elektronen anzuziehen und dadurch die Elektronenentladung zu initiieren und aufrechtzuerhalten;
einer Vorrichtung (22) zum Kalten des Substrates (20) in dem Pfad eines Gas-, Ionen- und -Strahlungsplasmas, das durch die Kammeröffnung (18) emittiert wird; und
einer Vorrichtung (24) zum Bilden eines Flusses, der Partikel aus wenigstens einer anderen Substanz der Verbindung umfaßt, und zum Führen des Flusses auf das Substrat (20), damit es darauf mit dem Plasma reagieren kann.

22. Die Vorrichtung nach Anspruch (21), welche weiter umfaßt:
eine Hohlkathode (14), die sich in die Kammer (8) erstreckt;
einen Einlaß (40), der sich innerhalb der Hohlkathode (14) befindet und der im wesentlichen Emissions-Material-frei ist, wobei der Einlaß (40) und die Hohlkathode (14) für einen Flußpfad für ein Gas aus der einen Substanz in die Kammer (8) sorgen;
eine Vorrichtung zum ausreichenden Erwärmen des Einlasses (40), damit er Elektronen ausstrahlt und Gas aus der einen Substanz, das durch die Kathode (14) und den Einlaß (40) fließt, wenigstens partiell ionisiert;
einem Eintrittstor (60), das von dem Einlaß (40) getrennt ist, um den Fluß eines Gases aus der einen Substanz in die Kammer (8) zu erlauben;
eine Vorrichtung, die für einen Fluß eines Gases aus der einen Substanz in die Kammer (8) durch den Einlaß (40) und das Eintrittstor (60) sorgt;
eine Vorrichtung (16) zum Anlegen einer Spannung an die Kathode (14), die relativ zu der Anode (28) ausreichend niedrig ist, um eine ionisierende Entladung zwischen der Kathode (14) und der Anode (28) zu erzeugen und dadurch ein Plasma innerhalb der Kammer (8) zu errichten, wenn ionisiertes Gas in die Kammer (8) durch die Kathode (14) einführt wird.

23. Die Vorrichtung nach Anspruch 21 oder 22, die des weiteren ein feines Drahtnetz umfaßt, das über die Öffnung (18) plaziert wird.

## Revendications

1. Un procédé de présentation d'une substance d'un composé pour la croissance épitaxiale par jets moléculaires (ou MBE) sur un substrat (20), comprenant les étapes suivantes :
on forme un plasma comprenant un mélange d'ions de la substance précitée, de particules neutres de cette substance et d'électrons,
on génère un rayonnement à partir de la substance précitée, et
on dirige ce rayonnement en compagnie du plasma vers le substrat (20),
dans lequel le plasma est formé en bombardant avec des électrons un gaz de la substance précitée.

2. Le procédé de la revendication 1, dans lequel on bombarde le gaz avec des électrons pour produire des ions et des particules excitées de la substance précitée, et le rayonnement précité comprend un rayonnement d'ionisation qui résulte de la neutralisation de certains au moins des ions, et un rayonnement d'excitation qui résulte de la relaxation spontanée de certaines au moins des particules excitées.

3. Le procédé des revendications 1 ou 2, dans lequel on forme le plasma en faisant entrer un gaz de la substance précitée dans une chambre (8) à travers une cathode creuse (14), cette cathode creuse (14) comprenant une pièce rapportée (40) formée par un matériau qui est pratiquement dépourvu de tout mélange émetteur d'électrons, on chauffe suffisamment cette pièce rapportée (40) pour qu'elle émette des électrons dans le gaz qui traverse la cathode (14) et pour qu'elle ionise au moins partiellement ce gaz, on admet dans la chambre (8) un écoulement de gaz de la substance précitée, à travers un orifice d'entrée (52) séparé de la cathode (14), et on applique à la cathode (14) une tension suffisante pour établir le plasma à l'intérieur de la chambre (8).

4. Le procédé de la revendication 3, dans lequel la pièce rapportée (40) consiste en une feuille de métal réfractaire enroulée.

5. Le procédé de la revendication 4, dans lequel la pièce rapportée (40) consiste en tantale.

6. Le procédé de l'une quelconque des revendications précédentes, dans lequel on forme le plasma dans la chambre (8) et on le fait diffuser vers le substrat (20) à travers une ouverture (18) dans la chambre (8).

7. Le procédé de la revendication 6, dans lequel un treillis en fil métallique fin est placé sous l'ouverture (18) dans la chambre (8).

8. Le procédé de l'une quelconque des revendications précédentes, dans lequel le plasma est étali à une pression relativement basse, dans la plage de 133,3 x 10⁻⁵ - 133,3 x 10⁻⁴ Pa (10⁻⁵ - 10⁻⁴ Torr).

9. Le procédé de l'une quelconque des revendications précédentes, dans lequel le plasma est formé par une décharge à courant continu d'électrons dans un gaz de la substance précitée.

10. Le procédé de la revendication 9, dans lequel les proportions relatives d'ions et de particules neutres dans le plasma sont commandées par la commande de la tension à laquelle des électrons sont déchargés dans le gaz et du courant de décharge.

11. Le procédé de l'une quelconque des revendications précédentes, comprenant en outre les étapes suivantes :
on forme un flux comprenant des particules d'au moins une autre substance dans le composé, et
on dirige ce flux vers le substrat (20) pour le faire réagir avec le plasma sur le substrat.

12. Le procédé de l'une quelconque des revendications précédentes, dans lequel on établit le plasma avec un niveau d'ionisation d'environ 10%.

13. Le procédé de l'une quelconque des revendications précédentes, comprenant en outre l'étape qui consiste à appliquer une tension au substrat (20) pour commander la projection de particules chargées sur le substrat.

14. Le procédé de la revendication 13, dans lequel on fait varier la tension du substrat pendant la croissance épitaxiale sur le substrat, pour faire varier la densité d'ions ou d'électrons dans le plasma qui atteignent le substrat.

15. Le procédé de la revendication 11, dans lequel le flux de particules de l'autre substance consiste en un jet moléculaire qui est formé par évaporation d'une source (24) de cette autre substance.

16. Le procédé de la revendication 11, dans lequel le flux de particules de l'autre substance consiste en un plasma de cette autre substance.

17. Le procédé de la revendication 16, dans lequel le flux comprend en outre un rayonnement d'ionisation qui résulte de la neutralisation de certains au moins des ions de l'autre substance, et un rayonnement d'excitation qui résulte de la relaxation spontanée de particules excitées de cette autre substance.

18. Un procédé selon la revendication 11, dans lequel la substance précitée est le mercure (Hg).

19. Le procédé de la revendication 18, dans lequel l'autre substance est le tellure (Te₂).

20. Le procédé de la revendication 18, dans lequel l'autre substance est le tellurure de cadmium (CdTe).

21. Un appareil pour la croissance épitaxiale d'un composé, ayant un ensemble de substances constitutives, sur un substrat (20), comprenant :
une chambre (8) ayant une ouverture (18) d'un côté pour l'émission de gaz à partir de l'intérieur de la chambre (8),
des moyens pour introduire un gaz de l'une des substances dans la chambre,
des moyens pour décharger des électrons dans la chambre afin d'ioniser et d'exciter une partie au moins du gaz, des niveaux relatifs d'ionisation et d'excitation dépendant de la tension de décharge d'électrons et du courant d'émission, des particules de gaz excitées se relaxant spontanément en donnant des particules neutres et un rayonnement d'ionisation,
une anode (28) à l'intérieur de la chambre (8),
des moyens (16) pour maintenir l'anode (28) à une tension plus positive que la chambre (8), afin d'attirer des électrons et de déclencher et d'entretenir ainsi la décharge d'électrons,
des moyens (22) pour maintenir le substrat (20) dans le chemin d'un plasma de gaz, d'ions et de rayonnement qui est émis à travers l'ouverture (18) de la chambre, et
des moyens (24) pour former un flux comprenant des particules d'au moins une autre substance dans le composé, et pour diriger ce flux vers le substrat (20) pour qu'il réagisse avec le plasma sur le substrat.

22. Un appareil selon la revendication 21 et comprenant en outre :
une cathode creuse (14) qui pénètre dans la chambre (8),
une pièce rapportée (40) à l'intérieur de la cathode creuse (14) qui est pratiquement dépourvue de matériau émissif, cette pièce rapportée (40) et la cathode creuse (14) définissant un chemin d'écoulement pour un gaz de la substance précitée vers l'intérieur de la chambre (8),
des moyens pour chauffer suffisamment la pièce rapportée (40), pour qu'elle émette des électrons dans le gaz de la substance précitée circulant à travers la cathode (14) et la pièce rapportée (40) et pour qu'elle ionise au moins partiellement ce gaz,
un orifice d'entrée (60) séparé de la pièce rapporté (40) pour admettre dans la chambre (8) un écoulement de gaz de la substance précitée,
des moyens pour produire un écoulement de gaz de la substance précitée entrant dans la chambre (8) à travers la pièce rapportée (40) et l'orifice d'entrée (60), et
des moyens (16) pour appliquer à la cathode (14) une tension suffisamment basse par rapport à celle de l'anode (28) pour produire une décharge ionisante entre la cathode (14) et l'anode (28), et pour établir ainsi un plasma à l'intérieur de la chambre (8) lorsqu'un gaz ionisé est introduit dans la chambre (8) à travers la cathode (14).

23. Un appareil selon la revendication 21 ou 22 comprenant en outre un treillis en fil métallique fin placé sur l'ouverture (18).
